# EUROPÄISCHE PATENTSCHRIFT

(11) **EP 1 182 699 B1**
(45) Veröffentlichungstag und Bekanntmachung des Hinweises auf die Patenterteilung: **01.09.2010**
(21) Anmeldenummer: 01117972.8
(22) Anmeldetag: 24.07.2001
(51) Int. Cl.: H01L 21/762, H01L 21/764, H01L 21/311, H01L 29/06, H01L 27/08

(54) **Verfahren zur Bildung eines dicken dielektrischen Gebietes in einem Halbleitersubstrat**
Process for forming a thick dielectric region in a semiconductor substrate
Procédé de formation d'une région épaisse de diélectrique dans un substrat semiconducteur

(30) Priorität: 22.08.2000 DE 10041084
(43) Veröffentlichungstag der Anmeldung: 27.02.2002
(73) Patentinhaber: Infineon Technologies AG, 85579 Neubiberg (DE)
(72) Erfinder: Lachner, Rudolf, Dr., 85051 Ingolstadt (DE)
(74) Vertreter: Viering, Jentschura & Partner

(56) Entgegenhaltungen:
- EP-A- 0 996 149
- JP-A- 56 160 051
- JP-A- 58 042 251
- JP-A- 2000 183 149
- SHIEH B ET AL: "AIR GAPS LOWER K OF INTERCONNECT DIELECTRICS" SOLID STATE TECHNOLOGY, PENNWELL CORPORATION, TULSA, OK, US, Bd. 42, Nr. 2, Februar 1999 (1999-02), Seiten 51-52,54,57, XP000799181 ISSN: 0038-111X

## Beschreibung

Die vorliegende Patentanmeldung betrifft ein Verfahren zur Bildung eines dielektrischen Gebiets in einem Halbleitersubstrat.

Die elektrische Leistungsfähigkeit integrierter, passiver Bauelemente wie Polysiliziumwiderstände, Polysilizium-Polysilizium beziehungsweise Metall-Metallkapazitäten sowie Spulen wird oft durch parasitäre kapazitive Kopplungen mit dem verwendeten Halbleitersubstrat verschlechtert. Dies tritt insbesondere auf, wenn Halbleitersubstrate mit niedriger Leitfähigkeit verwendet werden. Die kapazitive Substratkopplung kann zu einer drastischen Verschlechterung von Hochfrequenzbauelementen führen. Um die Bauelemente von dem Substrat zu entkoppeln, kann eine dielektrische isolierende Schicht lokal unter den zu isolierenden Bauelementen angeordnet werden. Je dicker dabei die dielektrische Schicht ausgebildet ist, desto besser ist die Entkopplung der Bauelemente von dem Substrat. Es existieren bereits unterschiedliche Möglichkeiten, dicke Isolationsschichten zu erzeugen. Zur Isolation von Induktivitäten, die in der obersten Metallebene realisiert werden, können sehr dicke, organische Spin-On-Schichten wie Polyamid verwendet werden. Diese Materialien können allerdings wegen ihrer Temperaturempfindlichkeit nur am Prozeßende verwendet werden. Darüber hinaus weisen diese Schichten den Nachteil auf, daß aufgrund der großen Schichtdicke von zirka 10 µm eine nachfolgende hochauflösende Strukturierung erschwert wird. Dies bedeutet, daß diese Schichten lediglich zur Isolation der letzten Metallebene verwendet werden können, in der die Kontaktlochöffnungen zu darunterliegenden Schichten ohne Feinstrukturierung gebildet werden können und folglich einen großen Anteil der Substratoberfläche einnehmen.

Eine weitere Methode zur Entkopplung der Bauelemente von dem Substrat besteht darin, das Substrat unter den Bauelementen großflächig und tief zu entfernen. Dadurch sind die Bauelemente freischwebend über dem Substrat angeordnet. Diese Vorgehensweise bietet zwar eine gute Entkopplung, die mechanische Stabilität dieses Gebildes ist aber störanfällig und neigt zu Schwingungen. Darüber hinaus ist ein Verpacken der Schaltkreise in einem Gehäuse schwierig, da die freischwebenden Bauelemente nicht beschädigt werden sollten.

In der JP-A-56-160051 wird ein Herstellungsverfahren zur Bildung einer isolierenden Schicht beschrieben, bei der innerhalb eines größeren Gebietes eine Vielzahl von Gräben gebildet wird, die anschließend mit einem dielektrischen Material gefüllt werden. Nachdem die Zwischenräume zwischen den Gräben entfernt werden, wird ein weiterer dielektrischer Film aufgebracht, sodass nun eine großflächige Isolationsschicht entsteht.

In JP-A-58-042251 wird das Bilden einer größeren isolierenden Schicht gezeigt, bei der sich in einem Graben ausgebildete Isolationselemente mit denen einer später abgeschiedenen Isolationsschicht vereinen.

Weiterhin ist es möglich, sehr dicke dielektrische Schichten zum Beispiel durch CVD (Chemical Vaper Deposition) Verfahren oder thermische Oxidation auf dem Substrat zu bilden. Diese Verfahren weisen allerdings den Nachteil auf, daß sie extrem langsam sind und damit unwirtschaftlich arbeiten. Ein weiterer Nachteil besteht darin, daß die dicken dielektrischen Schichten nicht lokal, sondern über den gesamten Wafer erzeugt werden. Dies hat den Nachteil, daß eine nachfolgende Strukturierung der dicken Schicht nur grob erfolgen kann und eine Feinstrukturierung erschwert wird. Darüber hinaus erzeugt die dicke dielektrische Schicht eine extrem ungünstige Topographie auf der Substratoberfläche, so daß die nachfolgenden Prozeßschritte erschwert werden.

Es ist die Aufgabe der Erfindung, ein dielektrisches Gebiet in einem Bereich eines Halbleitersubstrats zu bilden, das eine vergrößerte Dicke und eine verbesserte Planarität aufweist.

Die erfindungsgemäße Aufgabe wird gelöst durch ein Verfahren zur Bildung eines dielektrischen Gebiets in einem Bereich eines Halbleitersubstrats gemäß Anspruch 1.

Die Erfindung bildet beispielsweise zunächst den ersten und den zweiten Graben, wobei ein Steg zwischen den beiden Gräben entsteht. Falls vorgesehen ist, daß ein relativ großer Bereich der Substratoberfläche mit einem dielektrischen Gebiet zu versehen ist, so wird zum Beispiel eine ganze Reihe von Gräben mit dazwischenliegenden Stegen gebildet. Die Gräben können dabei mit einer Tiefe gebildet werden, die der späteren Dicke des dielektrischen Gebiets entspricht. Die Gräben werden nun zunächst mit der ersten dielektrischen Schicht gefüllt, wobei lediglich eine Schichtdicke abzuscheiden ist, die in etwa der halben Grabenbreite entspricht. Dieser Prozeß ist im Vergleich zu einer dicken Schichtdicke der dielektrischen Schicht schnell und sehr preisgünstig. Nachfolgend wird ein Steg zwischen der abgeschiedenen ersten dielektrischen Schicht entfernt, wodurch ein dritter Graben entsteht. Der dritte Graben wird beispielsweise mit einer Tiefe gebildet, die in etwa der Tiefe des zuvor gebildeten ersten Grabens und damit der Fülltiefe der ersten dielektrischen Schicht entspricht. Dadurch wird die Herstellung sehr dicker dielektrischer Schichten in einem Halbleitersubstrat ermöglicht, die nicht durch Abscheidung entsprechend großer Schichtdicken, sondern durch konformes Auffüllen sehr tiefer Gräben realisiert wird. Zum Auffüllen der Gräben wird lediglich eine Schichtdicke benötigt, die in etwa der halben Grabenbreite entspricht.

In einer vorteilhaften Weiterbildung des erfindungsgemäßen Verfahrens wird die erste dielektrische Schicht planarisiert. Dieses Vorgehen hat zum einen den Vorteil, daß durch den Planarisierungsschritt der Steg zwischen dem ersten und dem zweiten Graben freigelegt wird und in einem nachfolgenden Ätzschritt entfernt werden kann. Weiterhin hat der Planarisierungsschritt den Vorteil, daß eine topologische Stufe zwischen der Oberfläche des Halbleitersubstrats und dem dielektrischen Gebiet vermieden wird.

Eine weitere Ausgestaltung des erfindungsgemäßen Verfahrens sieht vor, daß der Steg durch eine isotrope oder durch eine anisotrope Ätzung entfernt wird. Da der Steg zwischen zwei mit dielektrischem Material gefüllten Gräben angeordnet ist, kann der Steg durch eine isotrope Ätzung, die selektiv den Steg gegen die dielektrische Schicht in dem ersten und dem zweiten Graben entfernt, geätzt werden. Ebenfalls ist eine anisotrope Ätzung möglich, die zum Beispiel RIE (Reactive Ion Etch) verwendet, um gegen eine Lackmaske, gegen eine Hartmaske oder gegen den Materialunterschied von Steg zu dielektrischer Schicht selektiv ist.

Weiterhin ist vorgesehen, daß zur Bildung des ersten und zweiten Grabens eine Hartmaske verwendet wird. Die Verwendung einer Hartmaske hat den Vorteil, daß der erste Graben beziehungsweise der zweite Graben mit einer großen Grabentiefe gebildet werden kann.

Weiterhin ist vorgesehen, daß zur Bildung des dritten Grabens eine Lackmaske verwendet wird. Die Lackmaske kann zum Beispiel bei einer isotropen Ätzung dazu dienen, ein Fenster freizulegen, in dem der Steg angeordnet ist, so daß das übrige Substrat vor der Ätzung geschützt ist.

Eine weitere Ausgestaltung des erfindungsgemäßen Verfahrens sieht vor, daß die erste dielektrische Schicht in einem oberen Bereich des ersten und zweiten Grabens gebildet wird und in einem unteren Bereich, der unterhalb des oberen Bereichs angeordnet ist, ein Hohlraum entsteht. Der Hohlraum hat den Vorteil, daß eine verbesserte Entkopplung zwischen dem Substrat und dem Bauelement erreicht wird.

Weiterhin ist vorgesehen, daß die zweite dielektrische Schicht in einem oberen Bereich des dritten Grabens gebildet wird und in einem unteren Bereich, der unterhalb des oberen Bereichs angeordnet ist, ein zweiter Hohlraum entsteht. Der zweite Hohlraum hat den Vorteil, daß die Entkopplung zwischen dem Substrat und dem Bauelement weiter verbessert wird.

Weiterhin ist vorgesehen, daß der erste Hohlraum und der zweite Hohlraum zusammenhängend ausgebildet werden. Die zusammenhängende Ausbildung des ersten und zweiten Hohlraums hat den Vorteil, daß eine verbesserte Entkopplung zwischen dem Substrat und einem auf dem dielektrischen Gebiet angeordneten Bauelement erreicht wird.

Weitere vorteilhafte Ausgestaltungen der Erfindung sind Gegenstand der jeweiligen Unteransprüche.

Nachfolgend wird die Erfindung anhand von Ausführungsbeispielen und Figuren näher erläutert.

In den Figuren zeigen:
- Figur 1: ein Substrat mit einem Isolationsgraben;
- Figur 2: ein Substrat gemäß Figur 1, auf dem eine Maske ge- bildet ist;
- Figur 3: ein Substrat gemäß Figur 2, wobei die Maske zur Ät- zung von Gräben verwendet wurde;
- Figur 4: ein Substrat gemäß Figur 3, wobei die Gräben mit einer dielektrischen Schicht gefüllt sind;
- Figur 5: ein Substrat gemäß Figur 4, wobei die Substratober- fläche planarisiert ist;
- Figur 6: das Substrat aus Figur 5, wobei ein Steg zwischen den dielektrischen Schichten herausgeätzt wurde und ein Graben gebildet wurde;
- Figur 7: das Substrat gemäß Figur 6, wobei eine zweite die- lektrische Schicht auf dem Substrat und in einem Graben angeordnet ist;
- Figur 8: das Substrat gemäß Figur 7, wobei die erste dielek- trische Schicht und die zweite dielektrische Schicht als dielektrisches Gebiet dargestellt sind;
- Figur 9: eine Prozeßvariante, die sich an Figur 6 an- schließt, wobei eine zweite dielektrische Schicht auf dem Substrat abgeschieden wird, und ein Hohl- raum gebildet wird;
- Figur 10: das Substrat gemäß Figur 9, wobei die Substratober- fläche planarisiert ist;
- Figur 11: eine Prozeßvariante, die sich an Figur 3 an- schließt, wobei eine erste dielektrische Schicht auf der Substratoberfläche abgeschieden wird und einen Hohlraum in dem Substrat in einem der vorher geätzten Gräben bildet;
- Figur 12: das Substrat gemäß Figur 11, wobei die Substrato- berfläche planarisiert wurde;
- Figur 13: das Substrat gemäß Figur 12, wobei ein Steg, der zwischen zwei Gräben angeordnet war, entfernt wur- de;
- Figur 14: ein Substrat nach Figur 13, wobei eine zweite die- lektrische Schicht auf der Substratoberfläche abge- schieden ist und in dem Substrat ein Hohlraum ge- bildet ist;
- Figur 15: ein Substrat gemäß Figur 14, wobei die erste die- lektrische Schicht und die zweite dielektrische Schicht eine dielektrische Membran bilden, die ei- nen Hohlraum überspannt;
- Figur 16: die Draufsicht auf ein Substrat, wobei eine Graben- isolation angeordnet ist;
- Figur 17: das Substrat aus Figur 16, wobei ein erster Graben, ein Steg und ein zweiter Graben dargestellt sind.

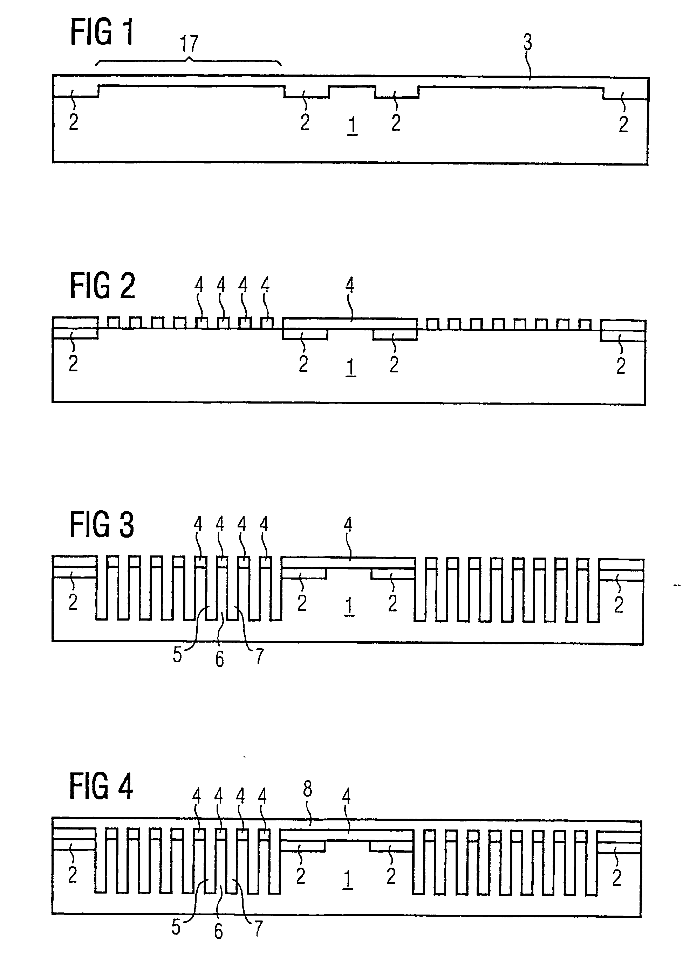

Die im folgenden in Figuren 4 bis 10 gezeigten Prozessvarianten dienen lediglich der Erläuterung.

Mit Bezug auf Figur 1 ist ein Substrat 1 dargestellt, in dem eine Grabenisolation 2 angeordnet ist. Die Grabenisolation 2 ist beispielsweise durch Abscheiden einer Isolationsschicht 3 auf die Oberfläche des Substrats 1 gebildet worden. Weiterhin ist ein Bereich 17 des Halbleitersubstrats 1 dargestellt.

Mit Bezug auf Figur 2 ist die Isolationsschicht 3 von der Oberfläche des Substrats 1 entfernt worden, wobei die Oberfläche des Substrats 1 beispielsweise mit einem CMP (Chemical Mechanical Polishing)-Schritt planarisiert worden ist. Auf der Oberfläche des Substrats 1 ist eine Maske 4 angeordnet, die strukturiert ist.

Ein nachfolgender Prozeßschritt gemäß Figur 3 sieht die Bildung eines ersten Grabens 5 und eines zweiten Grabens 7 vor, wobei zwischen dem ersten Graben 5 und dem zweiten Graben 7 ein Steg 6 stehenbleibt. Der Steg 6 ist beispielsweise mit der Maske 4 maskiert, so daß der zur Bildung des ersten Grabens 5 und des zweiten Grabens 7 durchgeführte Ätzschritt den Graben 6 stehen läßt. Die Ätzung zur Bildung des ersten Grabens 5 und des zweiten Grabens 7 wird beispielsweise anisotrop durchgeführt, um einen Graben mit hohem Aspektverhältnis (Grabentiefe zu Grabendurchmesser) zu bilden. Der Graben kann beispielsweise mit einem RIE (Reactive Ion Etch)-Schritt gebildet werden. Das Substrat 1 wird beispielsweise aus Silizium gebildet. Die Grabenisolation 2 ist als STI (Shallow Trench Isolation) gebildet und ist beispielsweise aus Siliziumoxid beziehungsweise einem dotierten Siliziumoxid oder Silikatglas gebildet. Die Maske 4 wird als Hartmaske gebildet und kann beispielsweise Siliziumoxid oder Siliziumnitrid enthalten.

Mit Bezug auf Figur 4 wird eine erste dielektrische Schicht 8 auf der Oberfläche des Substrats 1 beziehungsweise auf der Oberfläche der Maske 4 und in dem ersten Graben 5 und dem zweiten Graben 7 gebildet. Wird die erste dielektrische Schicht konform abgeschieden, so wird zur Füllung des ersten Grabens 5 beziehungsweise des zweiten Grabens 7 eine Schichtdicke benötigt, die in etwa der halben Grabenbreite des ersten Grabens 5 und des zweiten Grabens 7 entspricht. Hierzu kann beispielsweise ein CVD (Chemical Vaper Deposition)-Prozeß verwendet werden. Die erste dielektrische Schicht kann beispielsweise Siliziumoxid oder Siliziumnitrid enthalten.

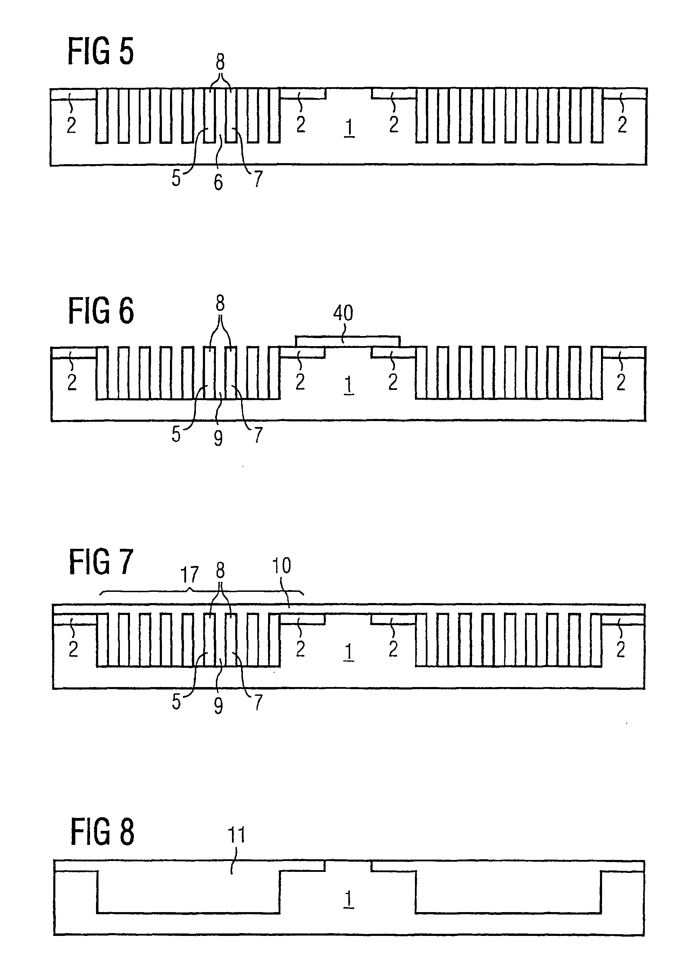

Mit Bezug auf Figur 5 wird die Oberfläche des Substrats 1 so bearbeitet, daß die erste dielektrische Schicht 8 und die Maske 4 von der Oberfläche des Substrats 1 entfernt werden. Dies kann beispielsweise mittels eines CMP-Schritts durchgeführt werden. Der CMP-Schritt hat weiterhin den Vorteil, daß die Oberfläche des Substrats 1 planarisiert wird. Vorteilhafterweise wird die Planarisierung so weit vorangetrieben, daß die Oberfläche des Stegs 6 freigelegt ist.

In Figur 6 ist eine unkritische Maske 40 so angeordnet, daß sie beispielsweise die Grabenisolation 2 überlappt und somit das Substrat 1 in einem Bereich freilegt, in dem ein dielektrisches Gebiets 11 zu bilden ist, und in einem Bereich schützt, in dem aktive Bauelemente gebildet werden können. An die unkritische Maske 40 werden keine hochauflösenden lithographischen Bedingungen gestellt, da die Grabenisolation 2 grob strukturiert ist. Anschließend wird der Steg 6 entfernt. Dies ist beispielsweise mit einer anisotropen oder einer isotropen Ätzung möglich. Die Ätzung kann dabei beispielsweise selbstjustiert zu den bereits in dem ersten Graben 5 und dem zweiten Graben 7 vorhandenen Oxidstegen, die aus der ersten dielektrischen Schicht 8 bestehen, durchgeführt werden.

Mit Bezug auf Figur 7 wird die unkritische Maske 40 entfernt und eine zweite dielektrische Schicht 10 auf der Oberfläche des Substrats 1 und auf der ersten dielektrischen Schicht in dem ersten Graben 5 und dem zweiten Graben 7 gebildet. Die zweite dielektrische Schicht 10 kann beispielsweise mit einem CVD-Prozeß abgeschieden werden. Dabei wird der dritte Graben 9 beispielsweise aufgefüllt. Dazu wird eine Schichtdicke für die zweite dielektrische Schicht 10 benötigt, die in etwa der halben Grabenbreite des dritten Grabens 9 entspricht.

Mit Bezug auf Figur 8 wird ein CMP-Schritt durchgeführt, der die Oberfläche des Substrats 1 planarisiert und die zweite dielektrische Schicht 10 von der Oberfläche des Substrats 1 entfernt. Die erste dielektrische Schicht 8 und die zweite dielektrische Schicht 10 bilden ein dielektrisches Gebiet 11. Die zweite dielektrische Schicht 10 kann ebenfalls Siliziumoxid oder Siliziumnitrid enthalten.

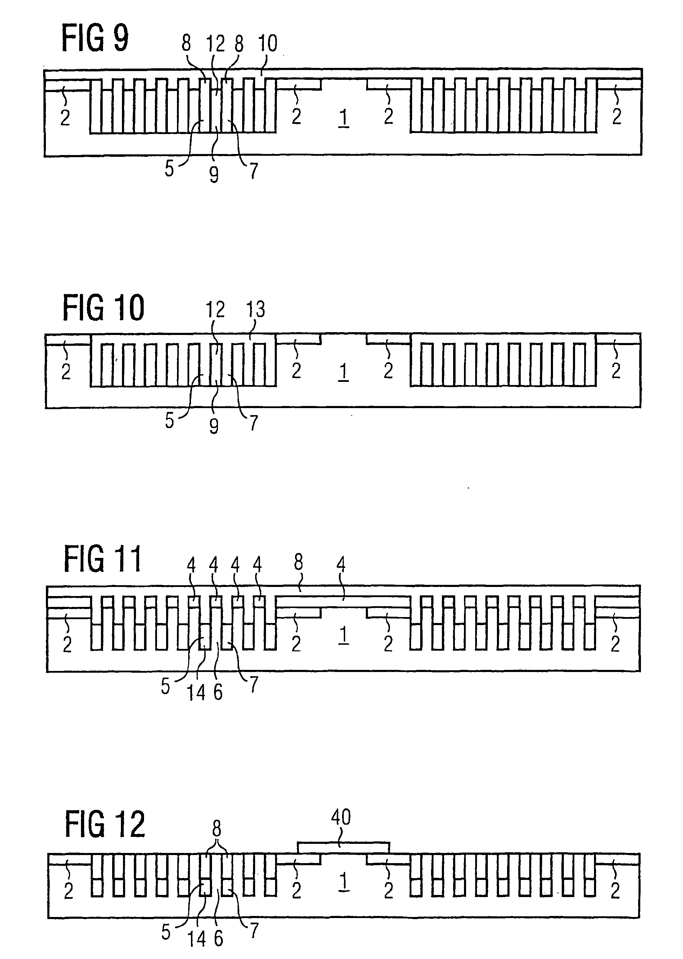

Mit Bezug auf Figur 9 ist eine Prozeßvariante dargestellt, die sich an Figur 6 anschließt. Es ist vorgesehen, daß der dritte Graben 9 nicht vollständig aufgefüllt wird, sondern ein zweiter Hohlraum 12 in dem Bereich des dritten Grabens 9 gebildet wird. Dazu wird auf die in Figur 6 dargestellte Struktur nach Entfernen der unkritischen Maske 40 die zweite dielektrische Schicht 10 auf dem Substrat 1 gebildet. Der Hohlraum 12 entsteht dadurch, daß die zweite dielektrische Schicht 10 mit einer verminderten Kantenbedeckung gebildet wird, wobei der Graben 9 in seinem oberen Bereich geschlossen wird, bevor der Graben 9 vollständig aufgefüllt ist. Die relative Dielektrizitätskonstante eines Hohlraums liegt in der Größenordnung 1, was eine Verbesserung gegenüber dem Material der ersten dielektrischen Schicht und der zweiten dielektrischen Schicht darstellen kann. Besteht die erste dielektrische Schicht beispielsweise aus Siliziumoxid, so weist sie eine relative Dielektrizitätskonstante von 4 auf. Dadurch wird die Entkopplung von Bauelementen verbessert, die auf dem dielektrischen Gebiet gebildet werden.

Mit Bezug auf Figur 10 wird eine Planarisierung der Oberfläche des Substrats 1 durchgeführt, wobei die zweite dielektrische Schicht 10 teilweise von der Substratoberfläche entfernt wird.

In Figur 11 ist die gemäß Anspruch 1 Prozeßvariante gezeigt, die sich an die in Figur 3 dargestellte Struktur anschließt. Es werden der erste Graben 5 und der zweite Graben 7 teilweise aufgefüllt, wobei in dem oberen Bereich der Gräben die erste dielektrische Schicht 8 die Gräben verschließt und in dem unteren Bereich des ersten und zweiten Grabens 5, 7 ein Hohlraum 14 gebildet wird. Dazu kann ein Abscheideprozeß verwendet werden, der eine verringerte Kantenbedeckung aufweist, so daß der erste und zweite Graben 5, 7 in seinem oberen Bereich geschlossen wird, bevor der erste und zweite Graben 5, 7 vollständig aufgefüllt ist, so daß sich der Hohlraum 14 in dem unteren Bereich der Gräben bildet. Die relative Dielektrizitätskonstante des Hohlraums liegt dabei in der Größenordnung 1, was gegenüber einem Siliziumoxid mit einer relativen Dielektrizitätskonstante von etwa 4 eine Verbesserung darstellt.

Mit Bezug auf Figur 12 wird die Oberfläche des Substrats 1 zurückgeätzt und planarisiert, wobei die erste dielektrische Schicht 8 wieder teilweise entfernt wird. Anschließend wird eine unkritische Maske 40 auf der Oberfläche des Substrats angeordnet, die beispielsweise die Grabenisolation 2 teilweise überlappt.

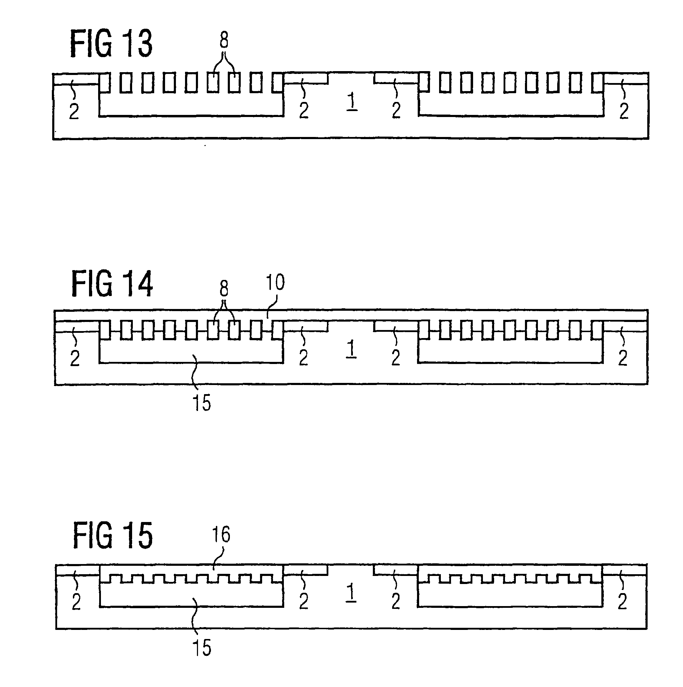

Mit Bezug auf Figur 13 wird ein Ätzprozeß durchgeführt, bei dem der Steg 6, der zwischen dem ersten Graben 5 und dem zweiten Graben 7 angeordnet ist, die in ihrem oberen Bereich jeweils mit der ersten dielektrischen Schicht 8 gefüllt sind, entfernt wird.

Mit Bezug auf Figur 14 wird die zweite dielektrische Schicht 10 auf der Oberfläche des Substrats 1 gebildet. Auch hierzu wird ein Abscheideprozeß verwendet, der eine verringerte Kantendeckung aufweist, so daß zwischen den freischwebenden Strukturen der ersten dielektrischen Schicht 8 die zweite dielektrische Schicht 10 gebildet wird.

Mit Bezug auf Figur 15 bilden die erste dielektrische Schicht 8 und die zweite dielektrische Schicht 10 eine dielektrische Membran 16, die einen dritten Hohlraum 15 überspannt.

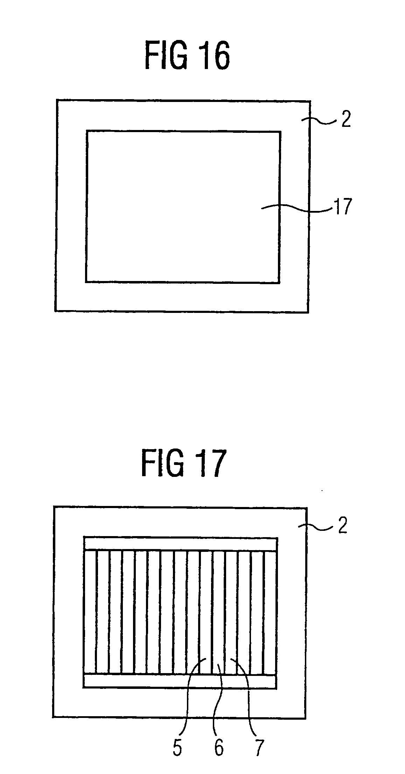

Figur 16 zeigt eine Draufsicht auf ein Substrat 1, das einen geschlossenen Ring als Grabenisolation 2 aufweist.

In Figur 17 ist eine Draufsicht gemäß Figur 16 gezeigt, bei der in der Innenfläche, die von der Grabenisolation 2 umgeben wird, ein erster Graben 5, ein Steg 6 und ein zweiter Graben 7 gebildet wird, wobei der Steg 6 zwischen dem ersten Graben 5 und dem zweiten Graben 7 angeordnet ist.

## Patentansprüche

1. Verfahren zur Bildung eines dielektrischen Gebiets in einem Bereich (17) eines Halbleitersubstrats (1) mit den Schritten:
- Bilden eines ersten Grabens (5) und eines zweiten Grabens (7) in dem Bereich (17) des Halbleitersubstrats (1), wobei ein Steg (6) zwischen dem ersten Graben (5) und dem zweiten Graben (7) gebildet wird;
- Bilden einer ersten dielektrischen Schicht (8) in dem ersten Graben (5) und dem zweiten Graben (7);
- Entfernen des Stegs (6), wodurch ein dritter Graben (9) entsteht;
- Bilden einer zweiten dielektrischen Schicht (10) in dem dritten Graben (9),
wobei die erste dielektrische Schicht (8) in einem oberen Bereich des ersten und zweiten Grabens (5, 7) gebildet wird und wobei in einem unteren Bereich des ersten und zweiten Grabens (5, 7), der unterhalb des oberen Bereichs des ersten und zweiten Grabens (5, 7) angeordnet ist, ein Hohlraum (14) gebildet wird.

2. Verfahren nach Anspruch 1,
**dadurch gekennzeichnet, daß**
die erste dielektrische Schicht (8) planarisiert wird.

3. Verfahren nach einem der Ansprüche 1 oder 2,
**dadurch gekennzeichnet, daß**
der Steg (6) durch eine isotrope oder eine anisotrope Ätzung entfernt wird.

4. Verfahren nach einem der Ansprüche 1 bis 3,
**dadurch gekennzeichnet, daß**
zur Bildung des ersten und zweiten Grabens (5, 7) eine Maske (4) verwendet wird.

5. Verfahren nach einem der Ansprüche 1 bis 4,
**dadurch gekennzeichnet, daß**
zur Bildung des dritten Grabens (9) eine Lackmaske oder eine Hartmaske verwendet wird.

6. Verfahren nach einem der Ansprüche 1 bis 5,
**dadurch gekennzeichnet, daß**
die zweite dielektrische Schicht (10) in einem oberen Bereich des dritten Grabens (9) gebildet wird und daß in einem unteren Bereich des dritten Grabens (9), der unterhalb des oberen Bereichs des dritten Grabens (9) angeordnet ist, ein zweiter Hohlraum (12) gebildet wird.

7. Verfahren nach Anspruch 6,
**dadurch gekenntzeichnet, daß**
der Hohlraum (14) und der zweite Hohlraum (12) zusammenhängend ausgebildet werden.

## Claims

1. Method for forming a dielectric zone in a region (17) of a semiconductor substrate (1) with the steps:
forming a first trench (5) and a second trench (7) in the region (17) of the semiconductor substrate(1), wherein a web (6) is formed between the first trench (5) and the second trench (7);
forming a first dielectric layer (8) in the first trench (5) and the second trench (7);
removing the web (6), a third trench (9) thereby being produced;
forming a second dielectric layer (10) in the third trench (9),
wherein the first dielectric layer (8) is formed in an upper region of the first and second trench (5, 7) and wherein in a lower region of the first and second trench (5, 7), that is disposed below the upper region of the first and second trench (5, 7), a cavity (14) is formed.

2. The method according to claim 1, **characterized in that** the first dielectric layer (8) is planarized.

3. The method according to any of claims 1 or 2, **characterized in that** the web (6) is removed by an isotropic or an anisotropic etching.

4. The method according to any of claims 1 to 3, **characterized in that** a mask (4) is used for forming of the first and second trench (5, 7).

5. The method according to any of claims 1 to 4, **characterized in that** a resist mask or a hard mask is used for forming of the third trench (9).

6. The method according to any of claims 1 to 5, **characterized in that** the second dielectric layer (10) is formed in an upper region of the third trench (9) and that in a lower region of the third trench (9), that is disposed below the upper region of the third trench (9), a second cavity (12) is formed.

7. The method according to claim 6, **characterized in that** the cavity (14) and the second cavity (12) are formed in a contiguous manner.

## Revendications

1. Procédé de formation d'une région diélectrique dans une zone (17) d'un substrat (1) semi-conducteur, comprenant les stades dans lesquels,
- on forme un premier sillon (5) et un deuxième sillon (7) dans la zone (17) du substrat (1) semi-conducteur, en formant une nervure (6) entre le premier sillon (5) et le deuxième sillon (7) :
- on forme une première couche (8) diélectrique dans le premier sillon (5) et dans le deuxième sillon (7) ;
- on élimine la nervure (6) en créant ainsi un troisième sillon (9) ;
- on forme une deuxième couche (10) diélectrique dans le troisième sillon (9) ;
dans lequel on forme la première couche (8) diélectrique dans une zone supérieure du premier et du deuxième sillons (5, 7) et dans lequel on forme une cavité (14) dans une zone inférieure du premier et du deuxième sillons (5, 7) qui est disposé en dessous de la zone supérieure du premier et du deuxième sillons (5, 7).

2. Procédé suivant la revendication 1,
**Caractérisé en ce que** on planarise la première couche (8) diélectrique.

3. Procédé suivant l'une des revendications 1 ou 2, **caractérisé en ce que** l'on élimine la nervure (6) par une attaque isotrope ou par une attaque anisotrope.

4. Procédé suivant l'une des revendications 1 à 3, **caractérisé en ce qu'**on utilise un masque (4) pour former le premier et le deuxième sillons (5, 7).

5. Procédé suivant l'une des revendications 1 à 4, **caractérisé en ce qu'**on utilise un masque de vernis ou un masque dur pour former le troisième sillon (9).

6. Procédé suivant l'une des revendications 1 à 5, **caractérisé en ce qu'**on forme la deuxième couche (10) diélectrique dans une zone supérieure du troisième sillon (9) et on forme une deuxième cavité (12) dans une zone inférieure du troisième sillon (9), qui est disposée en dessous de la zone supérieure du troisième sillon (9).

7. Procédé suivant la revendication 6, **caractérisé en ce qu'**on forme d'un seul tenant la cavité (14) et la deuxième cavité (12).
